# EUROPEAN PATENT APPLICATION

(11) **EP 3 461 927 A1**
(43) Date of publication of application: **03.04.2019**
(21) Application number: 17306283.7
(22) Date of filing: 27.09.2017
(51) Int. Cl.: C23C 14/24, C23C 14/30, H01J 37/305

(54) **ASSEMBLY AND CONTAINER FOR PHYSICAL VAPOR DEPOSITION WITH HEAT DISSIPATION**

(71) Applicant: Essilor International, 94220 Charenton-le-Pont (FR)
(72) Inventor: PAGNON, Philippe, 94220 CHARENTON-LE-PONT (FR)
(74) Representative: Petit, Maxime

(57) **Abstract**

It is proposed an assembly (10) com prising:
- a crucible (12) comprising at least one cavity (16),
- a container (14) for a material (15) to be vaporized, the container being intended to be disposed inside the cavity of the crucible and comprising:
• a container lateral surface (20) comprising an upper part (24) and a lower part (26), the upper part being configured to be at least partially in surface contact with a cavity lateral surface when the container is disposed inside the cavity, the lower part being configured to be distant from the cavity lateral surface to form a free space (25) surrounding the container between the lower part and the cavity lateral surface when the container is disposed inside the cavity, and
• a container bottom surface (28) configured to be at least partially in contact with a cavity bottom surface.

## Description

The invention concerns an assembly for physical vapor deposition of a material layer on a surface. The invention further concerns a container specifically configured to be implemented in said assembly.

Layer deposition is a process applied in many industries to form coating so as to protect surfaces and/or to impart a variety of desired properties to said surfaces. For example, in optics, an antireflective or anti-reflection (AR) layer is a type of optical layer applied to the surface of lenses or other optical devices to reduce reflection.

Physical Vapor Deposition is a well-known process performed under vacuum in which a target consisting of a material is bombarded with an energy beam. The energy beam causes atoms from the target to transform into the gaseous phase. These atoms then precipitate into solid form, coating simultaneously the plurality of substrates in a vacuum chamber with a layer of the material.

Material to be vaporized is generally disposed in a liner, or container, lodged in a cavity of a crucible. Said crucible is configured to cool the liner along with the material so as to dissipate the large amount of heat generated by the energy beam bombarding. After the material is bombarded with the energy beam, the material melts and forms a cake of material. After an extended period of use, bulges are formed at the cake top surface rendering evaporation of the material difficult. Indeed, the more homogeneous the cake top surface is, the easier the evaporation is. If evaporation of the material is not sufficient, optical layers applied to the lenses or other optical devices are not enough homogeneous and thus non-compliant to expected quality standards.

When the cake of material is considered as being unable to provide a homogeneous optical layer, the cake is removed from the liner to replace the material to be vaporized. This replacing operation entails significant costs, especially because the layer deposition machine has to be stopped during this operation.

It has been established that heat dissipation between the liner and the crucible has a significant effect on the homogeneity of the cake top surface. Known devices comprise a liner having lateral external surfaces and a bottom external surface that are fully in contact with the surface of the cavity formed by the crucible to maximize heat dissipation. However, it has been observed that the cake top surface becomes heterogenous in a short period of use making it necessary to replace the material.

A problem that the invention aims to solve is to provide an assembly for depositing material layers on surfaces of a plurality of substrates allowing to keep a cake top surface homogeneous even after an extended period of use of this cake.

To solve this problem, the invention provides an assembly comprising:
- a crucible comprising at least one cavity having a cavity lateral surface and a cavity bottom surface,
- a container for a material to be vaporized by an electron beam gun on an ophthalmic lens, the container being intended to be disposed inside the cavity of the crucible and comprising:
   - a container lateral surface comprising an upper part and a lower part, the upper part being configured to be at least partially in surface contact with the cavity lateral surface when the container is disposed inside the cavity, the lower part being configured to be distant from the cavity lateral surface to form a free space surrounding the container between the lower part and the cavity lateral surface when the container is disposed inside the cavity, and
   - a container bottom surface configured to be at least partially in contact with the cavity bottom surface when the container is disposed inside the cavity.

Providing a container, or a liner, with a surface contact with the crucible cavity at a lateral upper part of the container while keeping a lateral lower part of the container distant from the cavity crucible respectively allows to minimize cooling at the bottom of the liner and focus cooling at the top of the liner. This distribution of heat transfer allows to ensure a temperature homogeneity on all parts of the cake (cake top surface and bottom part of the cake) even after an extended period of use.

According to an embodiment of the assembly, at least one among the upper and the lower part is a circumferential surface of the container.

According to an embodiment of the assembly, the free space is annular.

According to an embodiment of the assembly, the distance between the lower part and the cavity lateral surface is greater than or equal to 3 mm when the container is disposed inside the cavity.

According to an embodiment of the assembly, the container further comprises a flange portion projecting outwardly from the lower part, the upper part being formed onto the flange portion.

According to an embodiment of the assembly, the upper part comprises between 10 % and 40%, preferably between 20% and 30% of the container lateral surface and the lower part comprises between 60% and 90%, preferably between 70% and 80% of the container lateral surface

According to an embodiment of the assembly, the container bottom surface comprises a recess having a bottom hole allowing the recess to be in fluid communication with the free space.

According to an embodiment of the assembly, the container further comprises at least one upper hole formed at a container upper surface.

According to an embodiment of the assembly, said at least one upper hole is a through hole extending from the container upper surface to the free space to form a circulation channel in fluid communication with the free space.

According to an embodiment of the assembly, the at least one upper hole is a gripping means.

According to an embodiment of the assembly, the container lateral surface has a tapered shape and/or the cavity lateral surface has a tapered shape.

According to an embodiment of the assembly, the container is made of a material chosen in the group including molybdenum and tungsten.

According to an embodiment of the assembly, the container comprises a maximum cross-section lower than or equal to 25 mm.

According to an embodiment of the assembly, the cavity bottom surface is comprised in a plane and forms the lowest surface of the cavity.

It is also provided a container for a material to be vaporized by an electron beam gun on an ophthalmic lens, the container being specifically configured to be implemented in the assembly as described above, the container being intended to be disposed inside the cavity of the crucible and comprising:
- a container lateral surface comprising an upper part and a lower part, the upper part being configured to be at least partially in surface contact with the cavity lateral surface when the container is disposed inside the cavity, the lower part being configured to be distant from the cavity lateral surface to form a free space surrounding the container between the lower part and the cavity lateral surface when the container is disposed inside the cavity, and
- a container bottom surface configured to be at least partially in contact with the cavity bottom surface when the container is disposed inside the cavity.

The invention is described in more detail below by way of the figures that show only one preferred embodiment of the invention.
Figure 1 shows an assembly comprising a crucible and several containers of material disposed within cavities of said crucible.
Figure 2 shows a cross-section view of a container disposed within a cavity of a crucible.
Figures 3 and 4 show perspective views of the container shown on figures 1 and 2.

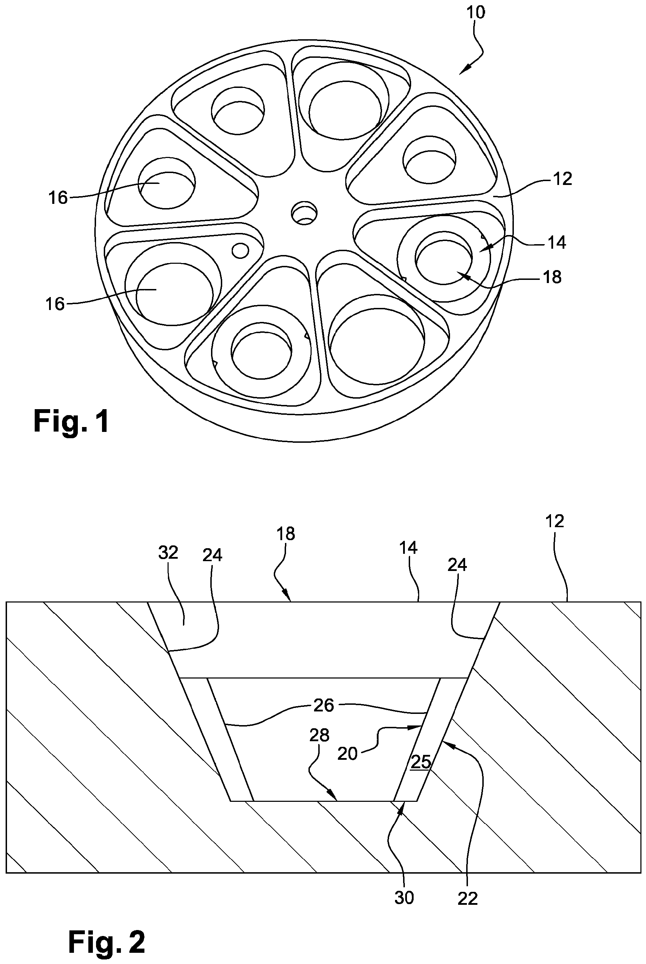

As shown on figure 1, an assembly 10 for Physical Vapor Deposition comprises a crucible 12 and a container 14, or liner, intended to be disposed inside a cavity 16 of the crucible 12. Said crucible 12 may have substantially the form of a disk comprising a plurality of cavities 16, also named "pockets", suitable for receiving a container 14 in each cavity 16. More generally, the assembly 10 may have a crucible 12 with at least one cavity 16 and at least one container 14 configured to be disposed within said cavity 16. The crucible 12 is preferably made in a material having a good thermal conductivity as copper. The container 14 is preferably made in molybdenum or tungsten.

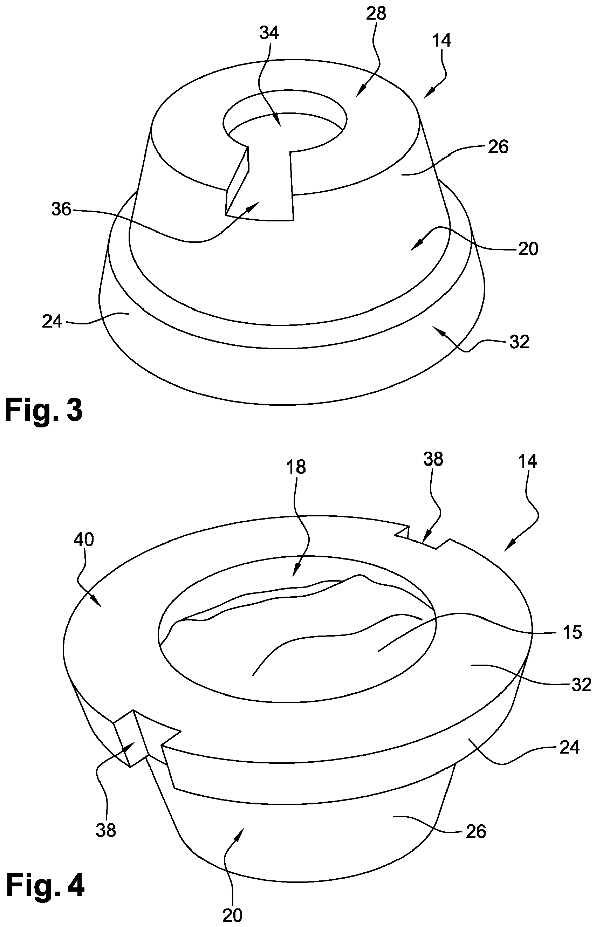

The container 14 is configured to receive a material 15 (shown on figure 4) to be vaporized by an electron beam gun on an ophthalmic lens. Particularly, the container 14 comprises a container cavity 18 configured to receive said material 15. When disposed in the container 14, said material 15 is bombarded with an energy beam by the electron beam gun to be vaporized and then applied to the surface of lenses or other optical devices. This application allows the surface of lenses or other devices to have a layer with specific properties, as for example an antireflective or anti-reflection (AR) layer to reduce reflection. Said material 15 is preferably in the form of a pellet, powders, or granulates. Said material 15 may be for example Zirconium Monoxyde (Zro), Tantalum oxide (Ta205) or Magnesium Fluoride (MgF2). More generally, said material 15 may be all kind of raw material to be deposited using a "cake" structure. Said material 15 is arranged in the container 14 so that the container 14 surrounds the material 15 but not the material 15 top surface. In other words, the container 14 holds said material 15 while leaving a top surface of the material 15 reachable by the electron beam gun to vaporize it. Furthermore, the crucible 12 is configured to cool the container 14 along with the material 15 therein so as to reduce temperature of the material 15.

As shown on figure 2, the container 14 comprises a container lateral surface 20 facing a cavity lateral surface 22 of the crucible when the container 14 is disposed within the cavity 16. The container lateral surface 20 comprises an upper part 24 configured to be at least partially in surface contact with the cavity lateral surface 22 when the container is disposed inside the cavity 16. Surface contact between the cavity lateral surface 22 and the upper part 24 means that a plurality of lines belonging to these two surfaces and extending along different directions are contacting each other when the container 14 is disposed inside the cavity 16. A surface contact allows the container 14 to be well maintained in the crucible cavity 16. Preferably, both of the container lateral surface 20 and the cavity lateral surface 22 have a tapered shape. Alternatively, at least one among the container lateral surface 20 and the cavity lateral surface 22 has a tapered shape. The container 14 preferably comprises a maximum cross-section lower than or equal to 25 mm.

Preferably, the cavity lateral surface 22 and the upper part 24 of the container lateral surface 20 are at least partially complementary shaped to perform an efficient surface contact. In other words, the complementarity of shape allows an effective contact surface on a larger area and thus improves the heat transfer between these two surfaces. Said surface contact between the upper part 24 and the cavity lateral surface 22 may be continuous or discontinuous.

Furthermore, the cavity lateral surface 22 and the upper part 24 are preferably tapered to ease insertion and withdrawal of the container 14 into or from the cavity 16. Moreover, when these two surfaces are tapered and complementary shaped, a stable position of the container 14 in the cavity 16 can be ensured. Alternatively, the cavity lateral surface 22 and the upper part 24 may be of any shape allowing at least a partial surface contact between these two surfaces.

The container lateral surface 20 further comprises a lower part 26 configured to be distant from the cavity lateral surface 22 to form a free space 25 surrounding the container 14 between the lower part 26 and the cavity lateral surface 22 when the container 14 is disposed inside the cavity 16. Preferably, the free space 25 is annular. The distance between the lower part 26 and the cavity lateral surface 22 is preferably greater than or equal to 3 mm when the container 14 is disposed inside the cavity 16.

To obtain a configuration in which the upper part 24 contacts the cavity lateral surface 22 and the lower part 26 is distant from the cavity lateral surface 22, either the container 14 or the cavity 16 or both of them are configured to achieved this. Indeed, this configuration may be achieved with a cavity lateral surface 22 comprising a flange portion extending inwardly so that only this flange portion would be able to contact the upper part 24 of the container lateral surface 20 while leaving the lower part 26 free of any contact. Alternatively, as shown on figure 2, the container 14 further comprises a flange portion 32 projecting outwardly from the lower part 26, the upper part 24 being formed onto the flange portion 32. In this latter case, upper 24 part and lower 26 parts are thus shifted relative to each other to obtain said configuration. The upper part 24 may comprise between 10 % and 40%, preferably between 20% and 30% of the container lateral surface 20 and the lower part 26 may comprise between 60% and 90%, preferably between 70% and 80% of the container lateral surface 20.

Upper 24 and lower 26 parts are preferably circumferential surfaces of the container 14. In other words, the container lateral surface 20 is an external surface of the container 14. Alternatively or in combination, one among the upper 24 and the lower 26 parts may be a surface of the container 14 formed in a groove or a recess.

Furthermore, the container 14 also comprises a container bottom surface 28 configured to be at least partially in contact with a cavity bottom surface 30 when the container 14 is disposed inside the cavity 16. Preferably, the container bottom surface 28 is in surface contact with the cavity bottom surface 30. Forming a bottom contact between the container 14 and the cavity 16 allows cooling of the material 15 while stabilizing the position of the container 14 within the cavity 16. The cavity bottom surface 30 is preferably comprised in a plane and forms the lowest surface of the cavity 16.

The configuration described above, i.e. providing contact of the upper part 24 and the container bottom surface 28 with the cavity 16 while avoiding any contact between the lower part 26 and the cavity 16, allows to provide homogeneous cooling of the material 15 disposed within the container 14 so as to obtain a homogeneous structure of the cake, i.e. at the top and bottom parts of the cake, even after an extended period of use. Contacts of the upper part 24 and the container bottom surface 28 with the cavity 16 are preferably direct. In other words, no intermediary element is preferably disposed between the upper part 24 and the cavity 16 or between the container bottom surface 28 and the cavity 16. Alternatively, contacts of the upper part 24 and the container bottom surface 28 with the cavity 16 may be indirect. In this latter case, an intermediary element is disposed between the upper part 24 and the cavity 16 or between the container bottom surface 28 and the cavity 16 or between both of them. This intermediary element may be for example a joint.

As shown on figure 3, the container bottom surface 28 may comprise a recess 34 having a bottom hole 36 allowing the recess 34 to be in fluid communication with the free space 25. The recess 34 allows to reduce cooling of the container 14 and to allow heat dissipation toward the free space 25 and the top of the container 14. The recess 34 may be in the form of a cylindrical hole extending longitudinally with respect to the container 14. To further reduce surface contact between the container bottom surface 28 and the cavity 16, the recess 34 is preferably opened at the container bottom surface 28. In other words, the container bottom surface 28 is preferably annular with the recess 34 disposed at the center of the container bottom surface 28. The bottom hole 36 opens laterally at the lower part 26 of the container lateral surface 20 to make the recess 34 in fluid communication with the free space 25. Alternatively to a single bottom hole 36, the recess 34 may comprise a plurality of bottom holes 36 opening in the free space to improve heat dissipation.

The container 14 preferably further comprises at least one upper hole 38 formed at a container upper surface 40, as shown on figure 4. To improve heat dissipation inside the cavity 16, said at least one upper hole 38 is a through hole extending from the container upper surface 40 to the free space 25 to form a circulation channel in fluid communication with the free space 25. When the container 14 comprises a flange portion 32, the at least one upper hole 38 is preferably a hole extending through the flange portion 32. This circulation channel thus allows hot air disposed within the free space 25 to be evacuated outside to thus improve cooling of the container 14. To further improve heat dissipation, the container preferably comprises a plurality of upper holes 38, for example two or three. These upper holes 38 are preferably evenly distributed around the container 14.

Furthermore, when the container comprises the recess 34 and the upper hole 38, heat dissipation is well improved by allowing the air to circulate from the bottom of the container 14 to the outside of the cavity 16.

In a preferred embodiment, the at least one upper hole 38 is a gripping means. Indeed, insertion and withdrawal of the container 14 inside or from the cavity 16 is a difficult operation to achieve because of the high temperatures and the contact between the container lateral surface 20 and the cavity lateral surface 22. By forming gripping means with the upper hole 38, it is possible to both improve heat dissipation and ease gripping of the container 14. When at least one upper hole 38 is a gripping means, the container preferably comprises a plurality of upper holes 38. The position of the upper holes 38 around the container 14 is chosen depending on the geometry of the extracting tool which is intended to cooperate with the gripping means. As an example, if the extracting tool is in the form of pliers, the upper holes 38 preferably diametrically face each other.

## Claims

1. An assembly (10) comprising:
- a crucible (12) comprising at least one cavity (16) having a cavity lateral surface (22) and a cavity bottom surface (30),
- a container (14) for a material (15) to be vaporized by an electron beam gun on an ophthalmic lens, the container being intended to be disposed inside the cavity of the crucible and comprising:
• a container lateral surface (20) comprising an upper part (24) and a lower part (26), the upper part being configured to be at least partially in surface contact with the cavity lateral surface when the container is disposed inside the cavity, the lower part being configured to be distant from the cavity lateral surface to form a free space (25) surrounding the container between the lower part and the cavity lateral surface when the container is disposed inside the cavity, and
• a container bottom surface (28) configured to be at least partially in contact with the cavity bottom surface when the container is disposed inside the cavity.

2. The assembly (10) according to claim 1, wherein at least one among the upper (24) and the lower (26) part is a circumferential surface of the container (14).

3. The assembly (10) according to claim 1 or 2, wherein the free space (25) is annular.

4. The assembly (10) according to any one of claims 1 to 3, wherein the distance between the lower part (26) and the cavity lateral surface (22) is greater than or equal to 3 mm when the container (14) is disposed inside the cavity (16).

5. The assembly (10) according to any one of claims 1 to 4, wherein the container (14) further comprises a flange portion (32) projecting outwardly from the lower part (26), the upper part (24) being formed onto the flange portion (32).

6. The assembly (10) according to any one of claims 1 to 5, wherein the upper part (24) comprises between 10 % and 40%, preferably between 20% and 30% of the container lateral surface (22) and the lower part comprises between 60% and 90%, preferably between 70% and 80% of the container lateral surface (22).

7. The assembly (10) according to any one of claims 1 to 6, wherein the container bottom surface (28) comprises a recess (34) having a bottom hole (36) allowing the recess (34) to be in fluid communication with the free space (25).

8. The assembly (10) according to any one of claims 1 to 7, wherein the container (14) further comprises at least one upper hole (38) formed at a container upper surface (40).

9. The assembly (10) according to claim 8, wherein said at least one upper hole (38) is a through hole extending from the container upper surface (40) to the free space to form a circulation channel in fluid communication with the free space (25).

10. The assembly (10) according to claim 8 or 9, wherein the at least one upper hole (38) is a gripping means.

11. The assembly (10) according to any one of claims 1 to 10, wherein the container lateral surface (20) has a tapered shape and/or the cavity lateral surface (22) has a tapered shape.

12. The assembly (10) according to any one of claims 1 to 11, wherein the container (14) is made of a material chosen in the group including molybdenum and tungsten.

13. The assembly (10) according to any one of claims 1 to 12, wherein the container (14) comprises a maximum cross-section lower than or equal to 25 mm.

14. The assembly (10) according to any one of claims 1 to 13, wherein the cavity bottom surface (30) is comprised in a plane and forms the lowest surface of the cavity (16).

15. A container (14) for a material (15) to be vaporized by an electron beam gun on an ophthalmic lens, the container being specifically configured to be implemented in the assembly (10) according to any one of claims 1 to 14, the container (14) being intended to be disposed inside the cavity (16) of the crucible (12) and comprising:
• a container lateral surface (20) comprising an upper part (24) and a lower part (26), the upper part being configured to be at least partially in surface contact with the cavity lateral surface when the container is disposed inside the cavity, the lower part being configured to be distant from the cavity lateral surface to form a free space (25) surrounding the container between the lower part and the cavity lateral surface when the container is disposed inside the cavity, and
• a container bottom surface (28) configured to be at least partially in contact with the cavity bottom surface when the container is disposed inside the cavity.
